Europäisches Patentamt

(19) **European Patent Office**

Office européen des brevets

(11) Publication number: **0 063 414**

**B1**

(12) **EUROPEAN PATENT SPECIFICATION**

(45) Date of publication of patent specification: **10.08.88**

(51) Int. Cl.⁴: **H 03 H 7/38,** H 03 H 7/01

(21) Application number: **82301490.7**

(22) Date of filing: **23.03.82**

(54) **Apparatus for coupling signals to or from a two-wire line.**

(30) Priority: **06.04.81 CA 374737**
**21.12.81 CA 392796**

(43) Date of publication of application:
**27.10.82 Bulletin 82/43**

(45) Publication of the grant of the patent:
**10.08.88 Bulletin 88/32**

(84) Designated Contracting States:
**DE FR GB IT NL SE**

(56) References cited:
**DE-A-2 952 259**
**FR-A- 959 693**
**US-A-1 624 682**
**US-A-3 987 375**
**US-A-4 378 470**

**Patent Abstracts of Japan, Vol. 4, No. 59 (E-9)**
**(541) 2. May 1980 page 25E9**

(73) Proprietor: **NORTHERN TELECOM LIMITED**
**1600 Dorchester Boulevard West**
**Montreal Quebec H3H 1R1 (CA)**

(72) Inventor: **Carsten, Ralph Thomas**
**32 Elterwater Avenue**
**Nepean Ontario, K2H 5J2 (CA)**
Inventor: **Nakhla, Michael Sobhy**
**1054 Barwell Avenue**
**Ottawa Ontario K2B 8H5 (CA)**
Inventor: **Bunner, Charles Brian David**
**13 Robertlee Drive**
**Carp Ontario K0A 1L0 (CA)**

(74) Representative: **Crawford, Andrew Birkby et al**
**A.A. THORNTON & CO. Northumberland House**
**303-306 High Holborn**
**London WC1V 7LE (GB)**

Courier Press, Leamington Spa, England.

## Description

This invention relates to apparatus for separately coupling both voice-band signals, via a filter, and above voice-band data signals in both directions to and from a two-wire line such as a telephone subscriber line.

Prior art filters have been designed to provide a desired attenuation-frequency characteristic when terminated with predetermined source and load impedances. Although known design procedures result in filters which perform in accordance with their design characteristics when properly terminated with the predetermined impedances, the design characteristics generally will not be satisfied if the termination impedances differ or vary from the predetermined values.

Thus the design of a filter for use with variable termination impedances presents a problem. This problem is particularly significant if the terminations of the filter may have widely variable impedances, such as is the case for a filter to be connected to a telephone subscriber line. Such lines have a nominal resistive impedance of typically 600 ohms, but in fact individual subscriber lines may have a complex impedance which is substantially different from this. Accordingly, a filter designed for termination with resistive impedances of 600 ohms, when connected to an actual subscriber line of different impedance, will not necessarily satisfy its design characteristics.

Accordingly, a need exists to provide a simpler form of filtering arrangement which can satisfy its design characteristics when terminated with various impedances. A particular need exists for filters which can be used with arbitrary telephone subscriber lines, especially for separating voice frequency signals and above voice-band data signals on such lines, without resorting to buffering or adaptive arrangements.

A low pass filter as described subsequently herein can be used for coupling voice-band signals to and from arbitrary telephone subscriber lines of widely variable and complex impedance without resorting to buffering or adaptive arrangements. Such a filter is particularly useful for coupling voice-band signals on such lines to telephone equipment, without also coupling to such equipment above voice-band data signals which can be carried on the lines.

The above-voice-band signals, for example data signals, must also be coupled to and from the two-wire line. To this end, a coupling network is needed which does not adversely affect the designed filter characteristics, couples the data signals to and from the two-wire line in a balanced manner, and avoids the data signals being attenuated by the filter components. In the former respect in particular the filter must provide a small attenuation ripple in the filter pass band, which should not be degraded by the presence of the data signal coupling network.

In Patent Abstracts of Japan, Vol. 4, No. 59 (E-9) (541), May 2, 1980 page 25 E9 corresponding to Japanese document No. 55-28606 there is disclosed a telephone subscriber line transmission system in which low pass and high pass filters are connected in parallel to the line for coupling respectively voice-band analog signals and higher frequency digital signals thereto. In such a system the provision of the high pass filter can adversely affect the filter characteristics required of the low pass filter.

An object of this invention is therefore to provide improved apparatus for coupling signals to or from a two-wire line.

According to this invention there is provided apparatus comprising: a two-wire line; a filter including a shunt capacitor, the filter having a predetermined pass band for coupling signals in the pass band to or from the two-wire line; characterized by further comprising: a transformer having at least one first winding and at least one second winding, the shunt capacitor of the filter and the at least one second winding of the transformer being coupled in series across the two-wire line; and means coupled in parallel with the at least one first winding, having a relatively low impedance at frequencies in the pass band and a relatively high impedance at frequencies outside the pass band of the filter; whereby signals at said frequencies outside the pass band of the filter can be coupled to or from the two-wire line via the transformer.

Preferably the transformer comprises two second windings connected in series with the capacitor, one on each side thereof, across the telephone subscriber line.

The means coupled in parallel with the at least one first winding preferably comprises a parallel resonant circuit which is resonant at a frequency in the stop band of the filter.

The invention will be further understood from the following description with reference to the accompanying drawings, in which:

Fig. 1 illustrates in a block diagram a telephone subscriber line including at each end of the line a low pass filter for separating voice frequency signals from higher frequency data signals on the line;

Fig. 2 illustrates an attenuation versus frequency characteristic of the low pass filter;

Fig. 3 is an equivalent circuit of the connections of the low pass filter;

Fig. 4 illustrates a low pass filter designed in accordance with the prior art;

Fig. 5 is a graph, and Fig. 6 is an illustration of filter responses in the pass band, with reference to which the disadvantages of the prior art low pass filter and the advantages of a low pass filter as described herein are explained;

Figs. 7, 8 and 9 illustrate three alternative forms of a low pass filter;

Fig. 10 illustrates the form of a data coupling network for coupling data signals to and from the telephone subscriber line; and

Figs. 11 and 12 illustrate alternative transformer coupling arrangements to that shown in Fig. 10.

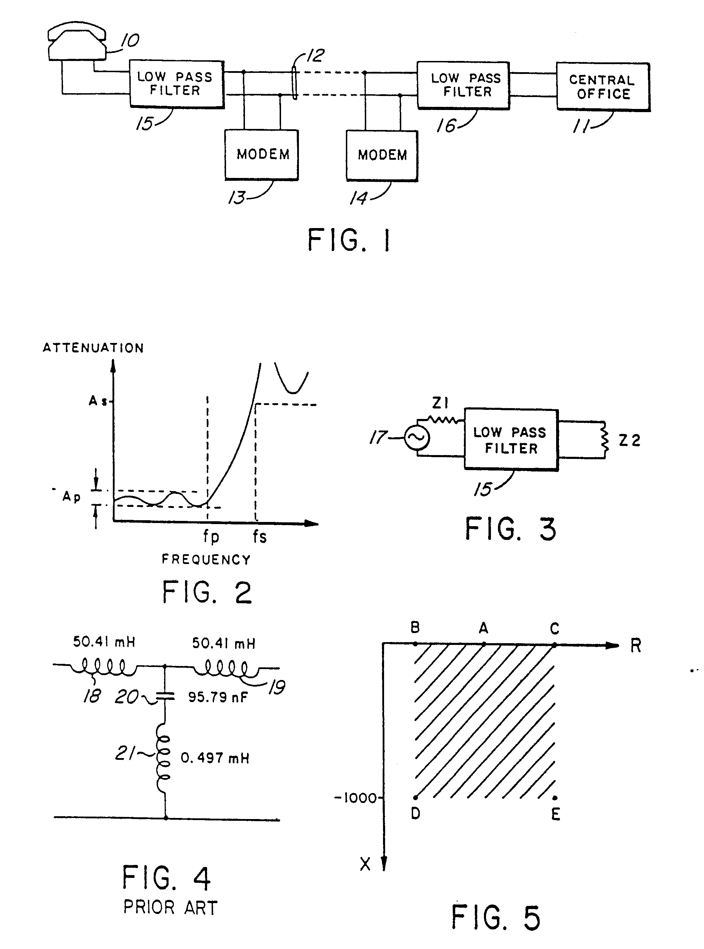

Referring to Fig. 1, a subscriber's telephone 10 is coupled to a telephone central office 11 via a conventional two-wire subscriber line 12. Modems 13 and 14 are also connected to the subscriber line 12 for transmitting data via the subscriber line between the locations of the telephone 10 and the central office 11, at a frequency, of for example 21kHz, which is above the voice frequency band. In order to prevent the data from passing to the telephone 10 and to the central office 11, these are coupled to the subscriber line 12 via low pass filters 15 and 16.

Fig. 2 illustrates the attenuation of a low pass filter as a function of frequency. Each of the filters 15 and 16 is required to have a characteristic including a pass band up to a frequency fp in which the filter has a maximum attenuation ripple, or variation, Ap, and a stop band from a frequency fs in which the filter has a minimum attenuation As. Typically fs=21kHz, As=60dB, fp=3200Hz, and Ap=±0.1dB relative to the attenuation at 1000Hz.

As shown by the equivalent circuit of Fig. 3, for example the low pass filter 15 is effectively driven by a voltage source 17 in series with an impedance Z1 connected to an input port of the filter, and is loaded by an impedance Z2. The source 17 and impedance Z1 correspond to the telephone 10, while the impedance Z2 corresponds to the subscriber line 12, both typically having nominal impedances of 600 ohms.

In order to determine a suitable form for each of the low pass filters, in the prior art the desired characteristic values fs, As, fp, and Ap have been used to design a filter to be terminated by resistive impedances Z1 and Z2. This design is particularly conveniently carried out using the computer design program FILSYN (see "FILSYN - A General Purpose Filter Synthesis Program", by G. Szentirmai, Proc. IEEE, Vol 65, No. 10, October 1977, pages 1443 to 1458). This program is used in known manner, initially being supplied with the desired characteristic values and resistive termination impedances Z1 and Z2 to determine a transfer function of the filter, and from this and the desired configuration of the filter to derive the form of a filter which satisfies the characteristic values and which is matched to the resistive termination impedances Z1 and Z2. This typically results in the form of filter shown in Fig. 4, which is a 3rd order filter having series inductors 18, 19 and a shunt path including a capacitor 20 in series with an inductor 21. Using the characteristic values and terminating impedances specified above, the elements 18 to 21 have values of 50.41mH, 50.41mH, 95.79nF, and 0.497mH respectively, as indicated in Fig. 4.

Fig. 5 is a complex impedance graph, for a frequency of 3000Hz, illustrating the resistance R and reactance X of various points A to E. The point A, of zero reactance and 600 ohm resistance, corresponds to the nominal termination impedances Z1 and Z2 for which the filter of Fig. 4 is designed as described above. However, the subscriber line 12 is in practice not a purely resistive and accurately known impedance but a capacitive impedance which typically falls anywhere within the shaded area of Fig. 5, bounded by the points B, C, D, and E.

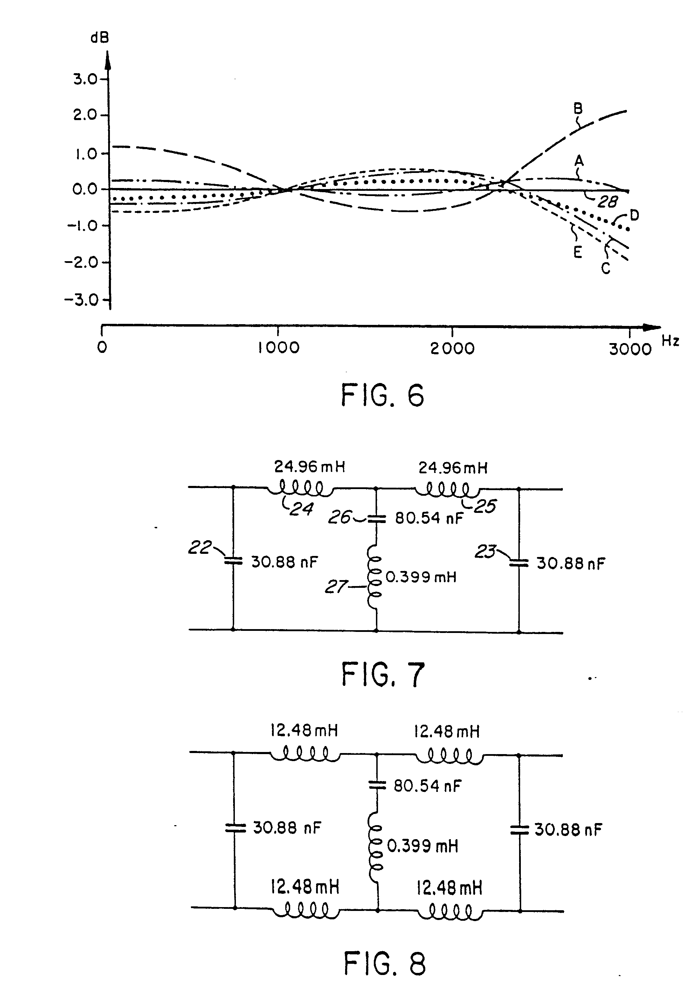

Fig. 6 illustrates the attenuation of the filter of Fig. 4 in its passband up to 3000Hz, relative to its attenuation at 1000Hz. when the filter of Fig. 4 is terminated with impedances corresponding to each of the points A to E in Fig. 5. As shown by the curve A, when the filter is terminated by the 600 ohm resistance for which it is designed according to the prior art, the filter attenuation is fairly constant throughout the passband, the ripple being within the design limit of Ap=±0.1dB. However, when the filter is terminated by the various impedances corresponding to the points B to E (100 ohms for point B, 2000 ohms for point C, 1288 ohms in parallel with 19.58nF for point D, and 2500 ohms in parallel with 10.56nF for point E), the filter attenuation in the passband changes as shown by the curves B to E respectively in Fig. 6, becoming much more variable so that the ripple greatly exceeds the design limit Ap.

Accordingly it can be seen that a filter such as that of Fig. 4, designed according to the prior art, can not be used with arbitrary subscriber lines 12 whose impedances fall anywhere within the shaded area of Fig. 5, if the design characteristics of the filter are to be satisfied. A result of this is that prior art filters must be individually designed for and/or matched to the subscriber lines with which they are to be used, in order to meet the required design characteristics. This individual design or matching is a great disadvantage because it is costly and time consuming and the filters are not readily interchangeable. Alternatively, much more complex and costly adaptive filters or buffered filters must be used.

This disadvantage is very largely avoided or substantially eliminated by designing each of the low pass filters 15 and 16 in accordance with the desired characteristics already discussed, but with the additional constraint that the quantities |Zin-Z2| and |Zout-Z1| be substantially minimized in the pass band of the filter. As already explained, Z1 and Z2 are the nominal input and output, respectively, termination impedances of the filter as shown in Fig. 3 (which may in this case be complex impedances rather than purely resistive impedances as in the prior art), Zin is the input impedance of the filter at its input port, and Zout is the output impedance of the filter at its output port. In order to substantially minimize the quantities |Zin-Z2| and |Zout-Z1|, conveniently their sum |Zin-Z2| + |Zout-ZI| is minimized.

Thus in order to design a suitable form for each of the low pass filters 15 16 the desired characteristic values fs, As, fp, and Ap and the nominal termination impedances Z1 and Z2 are used in the computer design program FILSYN to determine the transfer function of the filter, and from this and the desired configuration of the filter to determine a form of filter as in the prior art. Typically the result is a 3rd order filter as already described. This determined form of filter is then optimized, preferably using the computer aided design program SCAMPER (see Telesis, Volume 7, Number 3, 1980, pages 2 to 9, published by Bell-Northern Research Ltd.), to provide the best possible filter response. In the optimization process, component values of the filter are modified and updated if the modifications improve the filter response. The program SCAMPER is used with the additional constraint imposed in this program that the sum $|Zin-Z2| + |Zout-Z1|$ be minimized in the filter pass band. The SCAMPER program indicates that this can not be achieved with the number of variables provided by the determined form of the 3rd order filter. Accordingly, the FILSYN program is used again with the desired characteristic values and the nominal termination impedances with the additional requirement (not necessary in the prior art) that the filter be a higher order filter, e.g. a 5th order filter. As an alternative, a more restrictive pass band ripple Ap could be imposed upon the filter design using the FILSYN program, with a similar result. The resulting determined form of 5th order filter is then optimized using the SCAMPER program, again with the additional constraint imposed that the sum $|Zin-Z2| + |Zout-Z1|$ be minimized in the pass band. The resulting 5th order filter is typically as shown in Fig. 7, comprising shunt capacitors 22, 23, series inductors 24, 25, and a shunt path including a capacitor 26 in series with an inductor 27. Using the characteristic values and nominal terminating impedances discussed above and as used to determine the filter of Fig. 4 according to the prior art, the elements 22 to 27 have values of 30.88nF, 30.88nF, 24.96mH, 24.g6mH, 30.54nF, and 0.399mH respectively, as indicated in Fig. 7.

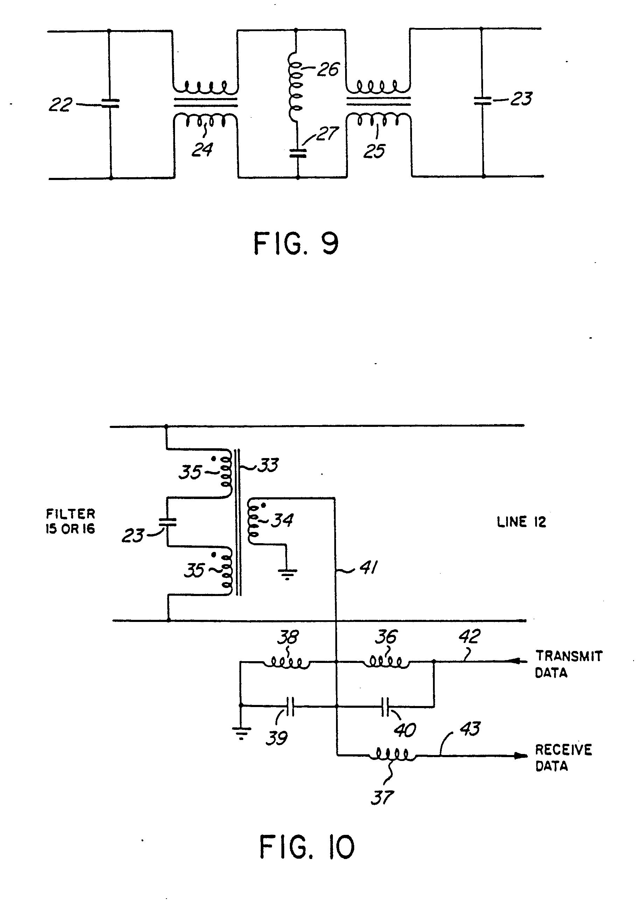

As illustrated in Fig. 8, the filter of Fig. 7 may be modified by providing the series inductances equally in the two wires of the filter, thereby balancinq the filter. Thus in Fig. 8 the series inductances are provided by four 12.48mH inductors. As is further illustrated in Fig. 9, each series inductance 24, 25 can be divided equally between the two wires of the filter and constituted by two coupled coils to provide small size and good longitudinal balance. The two coils of each inductance 24, 25 are conveniently bifilar wound, the inductance of each individual coil, measured with the coil to which it is coupled open-circuit, then being 6.24mH.

Referring again to Fig. 6, a solid line 28 illustrates the attenuation of the filter of Fig. 7, 8, or 9, relative to its attenuation at a frequency of 1000Hz, in the pass band up to 3000Hz. Unlike the prior art filter of Fig. 4, this attenuation is substantially the same throughout the passband regardless of the complex impedance, within the quadrant of the complex impedance graph of Fig. 5, with which the filter is terminated. Thus the line 28 in Fig. 6 represents the filter attenuation in the passband for all of the points A to E in Fig. 5.

It can thus be seen that the filter of Fig. 7, 8, or 9 can be used as each of the low pass filters 15 and 16 in Fig. 1 to provide the desired filter characteristics regardless of the nature of the particular subscriber line 12 which is used. Thus this relatively simple filter can be used interchangeably, without requiring expensive buffering or adjustment, on arbitrary subscriber lines 12, the desired low pass filter characteristics always being satisfied.

As shown in Figs. 7, 8. and 9 the shunt capacitor, for example 23, at the line 12 side of the low pass filter provides a low impedance across the line 12 for above voice-band signals. Consequently a problem arises in transmitting such signals between the modems 13 and 14 via the line 12 without excessive attenuation or loss of the signals due to the shunt capacitors of the filters. Furthermore, it is necessary to couple the modems 13 and 14 to the line 12 in such a manner that the design characteristics of the filters 15 and 16 are still complied with. This presents a significant problem in particular in maintaining the desired small attenuation ripple in the filter pass band.

Furthermore, it is desirable to provide for full duplex transmission of signals between the modems 13 and 14, simultaneously with the transmission of voice signals on the line 12. For example the signals transmitted from the modem 13 to the modem 14 may be FSK data signals at a center frequency of 36kHz and having actual frequencies of 35.5 and 36.5kHz, and the signals transmitted from the modem 14 to the modem 13 may be FSK data signals at a center frequency of 22kHz and having actual frequencies of 21.5 and 22.5kHz. These signal frequencies are assumed to be used in the following description, but other frequencies and types of signal transmission may be used.

In addition, the line 12 is generally a balanced line, and it is therefore generally desired to couple the data signals between the line and the modems in a balanced manner.

Fig. 10 shows a data coupling network with which the various desiderata above can be met. Fig. 10 shows only the shunt capacitor 23 of the filter 15 or 16 at the line 12 side of the respective filter, the remainder of the filter being as illustrated in Fig. 7, 8, or 9. In Fig. 10 the data coupling network comprises a transformer 33 having a first winding 34 and two second windings 35 phased as shown by dots, inductors 36. 37, and 38, and capacitors 39 and 40. The second windings 35 of the transformer 33 are coupled in series with the filter capacitor 23, one on each side thereof, across the line 12. The first winding 34 of, the transformer is connected between a wire 41 and circuit ground. With the wire 41 connected as described below, the transformer has a relatively small inductive reactance in the voice-band compared with the capacitive reactance of the capacitor 23, but the actual magnitude of this reactance is not critical because the low pass filter is designed to be insensitive to its terminations. The inductance of the transformer 33, measured across the first winding 34 with the capacitor 23 shorted and the second windings 35 open circuit, is relatively large (for example 8 to 10 times the inductance of the inductor 36) to avoid affecting the resonance described below of the inductor 36 with the capacitor 23.

Transmit data at the respective transmit frequency and present on a wire 42 is coupled to the wire 41 via the inductor 36. The inductance of the inductor 36 is selected so that it is series resonant with the filter capacitor 23, as reflected throuqh the transformer 33, at the transmit frequency. Thus the effect on the transmit data of the shunt capacitor 23 of the low pass filter is compensated by the inductor 36. Similarly the inductance of the inductor 37, which couples receive data from the wire 41 to a wire 43, is selected so that this inductor 37 is series resonant with the filter capacitor 23, as reflected through the transformer 33, at the respective receive frequency. Thus the effect on the receive data of the shunt capacitor 23 is compensated by the inductor 37. The series inductors 36 and 37 therefore facilitate efficient coupling of transmit and receive data between the wires 42 and 43 and the line 12.

In order to inhibit any component at the receive frequency the transmit data from reaching the line 41, the capacitor 40 is connected in parallel with the inductor 36 to form therewith a parallel resonant circuit which is resonant at the receive frequency.

The inductor 38 and the capacitor 39 are also connected in parallel to form a parallel resonant circuit which is connected between the wire 41 and circuit ground. The values of the components 38 and 39 are selected so that this circuit is resonant at the respective transmit frequency, so that this resonant circuit presents an open circuit to, and does not attenuate, the transmit data on the line 41. At voice frequencies this resonant circuit has a low impedance so that it is a virtual sort circuit across the first winding 34 of the transformer 33. Consequently in the filter pass band the second windings 35 of the transformer are virtual short circuits, so that the capacitor 23 is effectively connected directly across the line 12 as in Figs. 7, 8, and 9 and the pass band characteristics of the low pass filter are not degraded. In addition, the parallel resonant circuit reduces the effects of impulse noise, for example due to dial pulsing, on circuits connected to the wires 42 and 43, because of its virtual short circuit at voice frequencies where most of the energy of such noise is concentrated.

The parallel resonant circuit comprising the components 38 and 39 provides some attenuation of receive data at the receive frequency but this is readily compensated for by amplification of the receive data signals. This attenuation can be avoided by providing in place of the components 38 and 39 a more complicated circuit which is parallel resonant at both the receive and transmit frequencies, and has a low impedance in the voice-band.

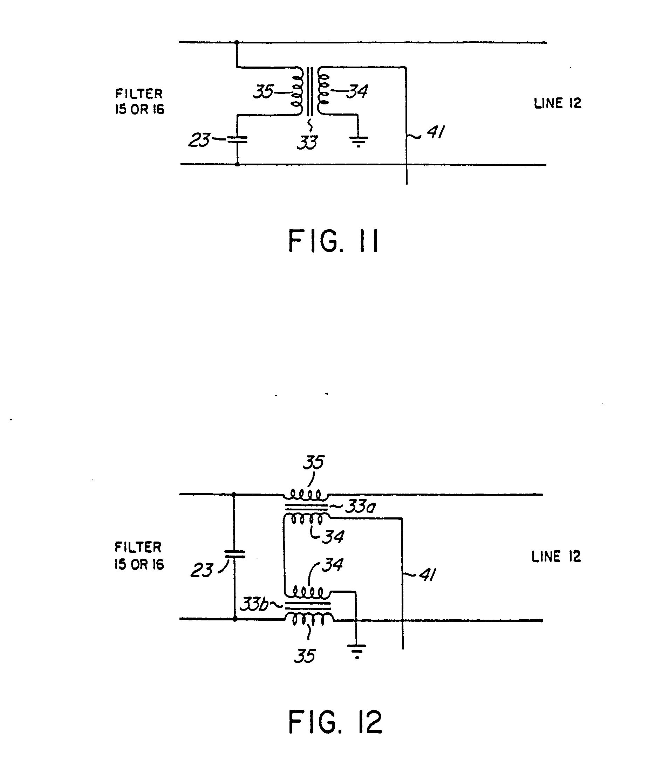

Fig. 11 illustrates an alternative arrangement to that of Fig. 10, showing only the filter capacitor 23 and the transformer 33 and their connections, which can be used to couple data signals to and from an unbalanced line 12. The remainder of the coupling network in this case, can be as illustrated in Fig. 10. In Fig. 11, the transformer 33 simply has in addition to the first winding 34 connected between the wire 41 and circuit ground, a single second winding 35 connected in series with the capacitor 23 across the line 12. This arrangement could also be used, if desired, for coupling data signals to and from a balanced line 12, but the arrangement of Fig. 10 is preferred.

Fig. 12 illustrates another alternative arrangement to that of Fig. 10, again showing only the filter capacitor 23 and the transformer 33 and their connections, which can be used to couple data signals to and from a balanced line 12. Again, the remainder of the coupling network can be as illustrated in Fig. 10. In Fig. 12, the transformer 33 is divided into two parts 33a and 33b, each of which has a first winding 34 and a second winding 35. The first windings 34 are connected in series between the wire 41 and circuit ground. The second windings 35 are connected each in series with a respective wire of the line 12, whereby the filter capacitor 23 is again connected across the line 12 via these windings 35. With appropriately phased second windings connected as shown in Fig. 12, the two parts 33a and 33b of the transformer could be combined into a single transformer 33 having a single first winding as shown in Fig. 10.

The transformer arrangement shown in Fig. 10 is preferred over that of Fig. 12, because the latter arrangement contributes additional d.c. resistance to the subscriber loop including the line 12. However, the arrangement of Fig. 12 can be used if the additional d.c. resistance in the subscriber loop provided by the second windings 35 is acceptable.

By way of example, it is observed that the components 38 and 39 may have magnitudes of 2.83mH and 18nF respectively for the transmit center frequency of 22kHz, and magnitudes of 4.6mH and 4.12nF respectively for the transmit center frequency of 36kHz.

Instead of the parallel resonant circuit 38, 39, as described above, coupled in parallel with the winding 34 any means, providing a relatively low impedance at frequencies in the pass band of the filter (e.g. the voice-band) to avoid degradation of the filter characteristics in tbe pass band, and providing a relatively high impedance to the signals to be coupled between, the wire 41 and the line 12, may be coupled in parallel with the winding 34 in place of the specific parallel resonant circuit described. In fact it should be appreciated that the parallel resonant circuit described constitutes a low pass filter connected in parallel with the winding 34, and any other suitable form of low pass filter could be used in its place.

Although the invention has been described in its application to a low pass filter for connection to a telephone subscriber line, in its broadest aspects as claimed it is not limited in its application thereto, nor is it limited to the types of filter to which it may be applied. Thus the principles of the invention can be applied to other than low pass filters, e.g. to high pass and band pass filters, for connection to telephone subscriber lines, and can be applied to the design of low pass or other filters for use in other applications where variable or unknown termination impedances may be present.

For example, if in the arrangement of Fig. 1 it were desired to prevent voice frequency signals on the telephone subscriber line 12 from reaching the modems 13 and 14, then a high pass filter could be provided between each modem and the line 12, each high pass filter being designed to have the sum |Zin-Z2| + |Zout-Z1| minimized in the pass band as described for the low pass filter above.

Furthermore, in other applications the form and order of the filter may vary from those described above, and in any event the particular impedances of the reactive components of the filter will be dependent upon the particular filter characteristics which are desired. Although the filter design described above uses the computer programs FILSYN and SCAMPER to determine the impedances of the reactive components of the filter, this being the preferred manner of effecting the filter design, the invention is not limited in this respect and other computer or manual design techniques may be used instead.

**Claims**

1. Apparatus comprising:
a two-wire line (12);
a filter (15) including a shunt capacitor (23) the filter having a predetermined pass band for coupling signals in the pass band to or from the two-wire line; characterized by further comprising;
a transformer (33) having at least one first winding (34) and at least one second winding (35), the shunt capacitor of the filter and the at least one second winding of the transformer being coupled in series across the two-wire line; and
means 38, 39) coupled in parallel with the at least one first winding, having a relatively low impedance at frequencies in the pass band and a relatively high impedance at frequencies outside the pass band of the filter;
whereby signals at said frequencies outside the pass band of the filter can be coupled to or from the two-wire line via the transformer.

2. Apparatus as claimed in claim 1 characterized in that the transformer (33) comprises two second windings (35) connected in series with the capacitor (25), one on each side thereof, across the two-wire line (12).

3. Apparatus as claimed in claim 1 or 2 characterized in that the means coupled in parallel with the at least one first winding comprises a parallel resonant circuit (38, 39) which is resonant at a frequency outside the pass band of the filter (15).

4. Apparatus as claimed in claim 1, 2 or 3 characterized in that the filter (15) is a low pass filter.

5. Apparatus as claimed in claim 4 characterized in that the filter comprises reactive components comprising in turn a shunt capacitance (22), a series inductance (24), a shunt capacitance (27) in series with an inductance (26), a series inductance (25), and a shunt capacitance (23).

6. Apparatus as claimed in any of claims 1 to 5 characterized in that the two-wire line (12) is a telephone subscriber line.

**Patentansprüche**

1. Vorrichtung mit:
einer Zweidraht-Leitung (12);
einem Filter (15) mit einem Nebenschluß-Kondensator (23), wobei der Filter ein vorbestimmtes Durchlaßband zum Einkoppeln von Signalen in dem Durchlaßband in die Zweidrahtleitung oder aus dieser besitzt, dadurch gekennzeichnet, daß weiter vorhanden ist:
ein Transformator (33) mit mindestens einer ersten Wicklung (34) und mindestens einer zweiten Wicklung (35), wobei der Nebenschlußkondensator des Filters und die mindestens eine zweite Wicklung des Transformators in Reihe quer zur Zweidrahtleitung angeschlossen sind, und
parallel mit der mindestens einer ersten Wicklung gekoppelte Mittel (38, 39) mit einer relativ niedrigen Impedanz bei Frequenzen im Durchlaßband und einer relativ hohen Impedanz bei Frequenzen außerhalb des Durchlaßbandes des Filters,
wodurch Signale bei den Frequenzen außerhalb des Durchlaßbandes des Filters über den Transformator in die Zweidrahtleitung eingekoppelt oder aus ihr ausgekoppelt werden können.

2. Vorrichtung nach Anspruch 1, dadurch gekennzeichnet, daß der Transformator (33) die beiden zweiten Wicklungen (35) in Reihe mit dem Kondensator (25) geschaltet enthält, und zwar jeweils eine zweite Wicklung an jeder Seite des Kondensators, und zwischen der Zweidrahtleitung (12).

3. Vorrichtung nach Anspruch 1 oder 2, dadurch gekennzeichnet, daß die parallel mit der mindestens einen ersten Wicklung gekoppelten Mittel einen Parallel-Resonanzkreis (38, 39) umfassen, der bei einer Frequenz außerhalb des Durchlaßbandes des Filters (15) in Resonanz ist.

4. Vorrichtung nach Anspruch 1, 2 oder 3, dadurch gekennzeichnet, daß das Filter (15) ein Tiefpaßfilter ist.

5. Vorrichtung nach Anspruch 4, dadurch gekennzeichnet, daß das Filter reaktive Komponenten umfaßt, die nacheinander einen Nebenschlußkondensator (22) eine Reiheninduktivität (24), einen Nebenschlußkondensator (27) in Reihe mit einer Induktivität (26), eine Reiheninduktivität (25) und einen Nebenschlußkondensator (23) umfassen.

6. Vorrichtung nach einem der Ansprüche 1 bis 5, dadurch gekennzeichnet, daß die Zweidrahtleitung (12) eine Fernsprech-Teilnehmerleitung ist.

## Revendications

1. Dispositif comprenant:
- une ligne à deux fils (12);
- un filtre (15) comportant un condensateur en dérivation (23), le filtre ayant une bande passante prédéterminée pour coupler les signaux dans la bande passante à la ligne à deux fils; caractérisé en ce qu'il comporte en outre:
- un transformateur (33) ayant au moins un premier enroulement (34) et au moins un second enroulement (35), le condensateur en dérivation du filtre et ledit au moins second enroulement du transformateur étant couplés en série entre la ligne à deux fils; et
- un moyen (38, 39) couplé en parallèle avec ledit au moins premier enroulement, ayant une impédance relativement faible aux fréquences de la bande passante et une impédance relativement élevée aux fréquences situées à l'extérieur de la bande passante du filtre;
- d'où il résulte que les signaux aux fréquences situées à l'extérieur de la bande passante du filtre peuvent être couplés à la ligne à deux fils via le transformateur.

2. Dispositif selon la revendication 1, caractérisé en ce que le transformateur (33) comprend deux seconds enroulements (35) connectés en série avec le condensateur (25), un de chaque côté de celui-ci, entre la ligne à deux fils (12).

3. Dispositif selon la revendication 1 ou la revendication 2, caractérisé en ce que le moyen couplé en parallèle avec ledit au moins premier enroulement comprend un circuit résonant parallèle (38, 39) qui résonne à une fréquence située à l'extérieur de la bande passante du filtre (15).

4. Dispositif selon la revendication 1, la revendication 2, ou la revendication 3, caractérisé en ce que le filtre (15) est un filtre passe-bas.

5. Appareil selon la revendication 4, caractérisé en ce que le filtre comprend des composants réactifs constitués tour à tour d'un condensateur en dérivation (22) d'une inductance en série (24), d'un condensateur en dérivation (27) en série avec une inductance (26), d'une inductance en série (25), et d'un condensateur en dérivation (23).

6. Dispositif selon l'une quelconque des revendications 1 à 5, caractérisé en ce que la ligne à deux fils (12) est une ligne d'abonné au téléphone.

FIG. 1

FIG. 2

FIG. 3

FIG. 4

PRIOR ART

FIG. 5

1

FIG. 6

FIG. 7

FIG. 8

FIG. 9

FILTER
15 OR 16

LINE 12

TRANSMIT
DATA

RECEIVE
DATA

FIG. 10

3

FIG. 11

FIG. 12